# EUROPEAN PATENT SPECIFICATION

(11) **EP 3 780 104 B1**
(45) Date of publication and mention of the grant of the patent: **24.08.2022**
(21) Application number: 19864283.7
(22) Date of filing: 06.06.2019
(51) Int. Cl.: H01L 27/146, H04N 5/225

(54) **CAMERA ASSEMBLY, ASSEMBLY METHOD THEREFOR, AND TERMINAL**
KAMERAANORDNUNG, MONTAGEVERFAHREN DAFÜR UND ENDGERÄT
ENSEMBLE CAMÉRA, SON PROCÉDÉ D'ASSEMBLAGE, ET TERMINAL

(30) Priority: 30.09.2018 CN 201811155503
(43) Date of publication of application: 17.02.2021
(73) Proprietor: Huawei Technologies Co., Ltd., Longgang District Shenzhen Guangdong 518129 (CN)
(72) Inventor: CAO, Xi, Shenzhen Guangdong 518129 (CN); RAN, Kun, Shenzhen Guangdong 518129 (CN); QING, Xiangyong, Shenzhen Guangdong 518129 (CN)
(74) Representative: Gill Jennings & Every LLP
(86) International application number: PCT/CN2019/090232
(87) International publication number: WO 2020/062915

(56) References cited:
- CN-A- 101 847 664
- CN-A- 106 206 485
- CN-A- 106 449 680
- CN-A- 108 323 034
- CN-A- 109 461 746
- US-A1- 2007 187 711
- US-A1- 2008 083 980
- US-A1- 2008 211 075

## Description

### TECHNICAL FIELD

This application relates to the field of semiconductor technologies, and more specifically, to a camera assembly, an assembly method, and a terminal.

### BACKGROUND

As the design of current mobile phones tends to be miniaturized and ultra-thin, the camera module, as an important module component of the mobile phone, also faces the challenges of miniaturization and ultra-thinness. In particular, the current high screen-to-body ratio and the full screen design have increased the need for a reduction in the outer dimensions of the camera module.The document US 2008/083980 A1 is a relevant prior art.

An architecture of a conventional camera module includes a printed circuit board (printed circuit board, PCB), a soldering process, a gold wire bonding process, and the like. Conventional PCBs are bulky, and the size of the PCB will direct affect the size of the camera module.

Therefore, how to reduce the height of the camera module becomes a problem that needs to be urgently resolved.

### SUMMARY

This application provides a camera assembly, an assembly method, and a terminal, so as to implement an electrical connection between electronic components through metal wiring at a redistribution layer (redistribution layer, RDL). Because the RDL is thinner than the PCB board in a conventional camera module, the electrical connection between electronic components is implemented by replacing the PCB with the RDL, so that the overall height of the camera module can be reduced.

According to a first aspect, a method for assembling a camera assembly is provided, including the following steps:
encapsulating a surface mount electronic component and an image sensor to form a target encapsulated module, where the target encapsulated module includes an active surface, and a solder end of the surface mount electronic component and the solder end of the image sensor are exposed on the active surface;
preparing a redistribution layer RDL, and drilling the RDL to form a through-hole, where the through-hole is opposite to a photosensitive area of the image sensor, the RDL includes a dielectric layer and metal wiring disposed at the dielectric layer, and the metal wiring is at least partially exposed on a first surface of the RDL; and connecting the metal wiring exposed on the first surface of the RDL to a solder end on the active surface of the target encapsulated module.

In this embodiment of this application, the electrical connection between the electronic components can be implemented through the metal wiring at the RDL. Because the RDL is thinner than the PCB board in a conventional camera module, when the electrical connection between the electronic components is implemented by replacing the PCB with the RDL, the overall height of the camera module can be reduced.

With reference to the first aspect, in any possible implementation of the first aspect, the method further includes: fixing an infrared filter to a second surface of the RDL. The second surface of the RDL faces away from the first surface of the RDL. The infrared filter is opposite the through-hole, and light passing through the infrared filter is incident on the image sensor through the through-hole.

In this embodiment of this application, the infrared filter can be fixed to the second surface of the RDL, so that the overall height of the camera module can be reduced.

With reference to the first aspect, in any possible implementation of the first aspect, the infrared filter is fixed in the through-hole.

In this embodiment of this application, the infrared filter can be fixed in the through-hole at the RDL, so that the impact of the infrared filter on the height of the camera module can be further reduced, and the overall height of the camera module can be reduced.

With reference to the first aspect, in any possible implementation of the second aspect, a motor is fixed to the second surface of the RDL.

With reference to the first aspect, in any possible implementation of the first aspect, further including: fixing a holder to the second surface of the RDL. The holder is configured to support the infrared filter. The infrared filter is opposite the through-hole, and light passing through the infrared filter is incident on the image sensor through the through-hole.

In this embodiment of this application, the infrared filter can be fixed to the second surface of the RDL using the holder, so that the infrared filter can be closer to the lens, and the infrared light can be better blocked from entering the image sensor.

With reference to the first aspect, in any possible implementation of the second aspect, a motor is fixed to the holder, and the motor and the RDL are respectively located on both sides of the holder.

With reference to the first aspect, in any possible implementation of the first aspect, the surface mount electronic component and the image sensor are placed on a tray fixture. The surface mount electronic component and the image sensor are wrapped by an encapsulating material.

In this embodiment of this application, the surface mount electronic component and the image sensor in the target encapsulated module can be positioned using the encapsulating material, so that the electrical connection between the electronic components can be better implemented.

Optionally, the encapsulating material is an epoxy resin material.

According to a second aspect, a camera assembly is provided, including a target encapsulated module and a redistribution layer RDL. The connection relationships between the foregoing modules are described in detail below.

A surface mount electronic component and an image sensor are encapsulated on the target encapsulated module. The target encapsulated module includes an active surface, and a solder end of the surface mount electronic component and the solder end of the image sensor are exposed on the active surface.

The redistribution layer RDL is provided with a through-hole. The through-hole is opposite a photosensitive area of the image sensor. The RDL includes a dielectric layer and metal wiring disposed at the dielectric layer. The metal wiring is at least partially exposed on a first surface of the RDL.

The metal wiring exposed on the first surface of the RDL is connected to a solder end on the active surface of the target encapsulated module.

In this embodiment of this application, the electrical connection between the electronic components can be implemented through the metal wiring at the RDL. Because the RDL is thinner than the PCB board in a conventional camera module, when the electrical connection between the electronic components is implemented by replacing the PCB with the RDL, the overall height of the camera module can be reduced.

With reference to the second aspect, in any possible implementation of the second aspect, the camera assembly further includes an infrared filter, where the infrared filter is fixed to a second surface of the RDL. The second surface of the RDL faces away from the first surface of the RDL. The infrared filter is opposite the through-hole, and light passing through the infrared filter is incident on the image sensor through the through-hole.

In this embodiment of this application, the infrared filter can be fixed to the second surface of the RDL, so that the overall height of the camera module can be reduced.

With reference to the second aspect, in any possible implementation of the second aspect, the camera assembly further includes an infrared filter, where the infrared filter is fixed in the through-hole.

In this embodiment of this application, the infrared filter can be fixed in the through-hole at the RDL, so that the impact of the infrared filter on the height of the camera module can be further reduced, and the overall height of the camera module can be reduced.

With reference to the second aspect, in any possible implementation of the second aspect, the camera assembly further includes a motor, where the motor is fixed to the second surface of the RDL.

With reference to the second aspect, in any possible implementation of the second aspect, the camera assembly further includes a holder and an infrared filter. The holder is configured to support the infrared filter. The holder is fixed to the second surface of the RDL. The infrared filter is opposite the through-hole, and light passing through the infrared filter is incident on the image sensor through the through-hole.

In this embodiment of this application, the infrared filter can be fixed to the second surface of the RDL using the holder, so that the infrared filter can be closer to the lens, and the infrared light can be better blocked from entering the image sensor.

With reference to the second aspect, in any possible implementation of the second aspect, the camera assembly further includes a motor, where the motor is fixed to the holder, and the motor and the RDL are respectively located on both sides of the holder.

With reference to the second aspect, in any possible implementation of the second aspect, the target encapsulated module further includes an encapsulating material. The encapsulating material surrounds a surface mount electronic component in the target encapsulated module and an image sensor.

In this embodiment of this application, the surface mount electronic component and the image sensor in the target encapsulated module can be positioned using the encapsulating material, so that the electrical connection between the electronic components can be better implemented.

Optionally, the encapsulating material is an epoxy resin material.

According to a third aspect, a terminal is provided, including a camera assembly according to the second aspect or any possible implementation of the second aspect and a processor configured to control the camera assembly.

### BRIEF DESCRIPTION OF DRAWINGS

FIG. 1 is a schematic block diagram of a method for assembling a camera assembly according to an embodiment of this application;
FIG. 2 is a schematic structural diagram of an assembled electronic component according to an embodiment of this application;
FIG. 3 is a schematic structural diagram of a target encapsulated module 300 according to an embodiment of this application;
FIG. 4 is a schematic structural diagram of an RDL and the target encapsulated module 300 according to an embodiment of this application;
FIG. 5 is a schematic structural diagram of a possible camera assembly 500 according to an embodiment of this application;
FIG. 6 is a schematic structural diagram of a possible camera assembly 600 according to an embodiment of this application; and
FIG. 7 is a schematic structural diagram of a possible camera assembly 700 according to an embodiment of this application.

### DESCRIPTION OF EMBODIMENTS

The following describes technical solutions of this application with reference to accompanying drawings.

It should be understood that the type of a terminal device mentioned in the embodiments of this application is not specifically limited, and the terminal device may include, but is not limited to, a mobile station (mobile station, MS), a mobile telephone (mobile telephone), user equipment (UE), a handset (handset), portable equipment (portable equipment), a cellular telephone, a cordless telephone, a session initiation protocol (session initiation protocol, SIP) telephone, a wireless local loop (wireless local loop, WLL) station, a personal digital assistant (personal digital assistant, PDA), a radio frequency identification (radio frequency identification, RFID) terminal device for logistics, a handheld device having a wireless communication function, a computing device, another device connected to a wireless modem, an in-vehicle device, a wearable device, or a terminal device in an Internet of Things or an Internet of vehicles.

By way of example but not limitation, in an embodiment of this application, the terminal device may alternatively be a wearable device. A wearable device may also be referred to as a wearable smart device, and is a general term for daily wearable devices that are smartly designed and developed by using wearable technologies, such as glasses, gloves, watches, apparels, and shoes. A wearable device is a portable device that can be worn directly on the body or integrated into the clothing or accessories of a user. The wearable device is not merely a hardware device, it can implement a powerful function based on software support, and data interaction, and cloud interaction. Generalized wearable smart devices include large-sized smart devices that can implement some functions without relying on a smartphone, such as smartwatches or smart glasses, and also include smart devices that focus on a particular application function and need to work with another device such as a smartphone, such as smart bands and smart jewelry that are used for sign monitoring.

An embodiment of this application provides a camera assembly, so as to implement electrical connection between electronic components through metal wiring at a redistribution layer (redistribution layer, RDL). Because the RDL is thinner than the PCB board in a conventional camera module, the electrical connection between the electronic components is implemented by replacing the PCB with the RDL, so that the overall height of the camera module can be reduced.

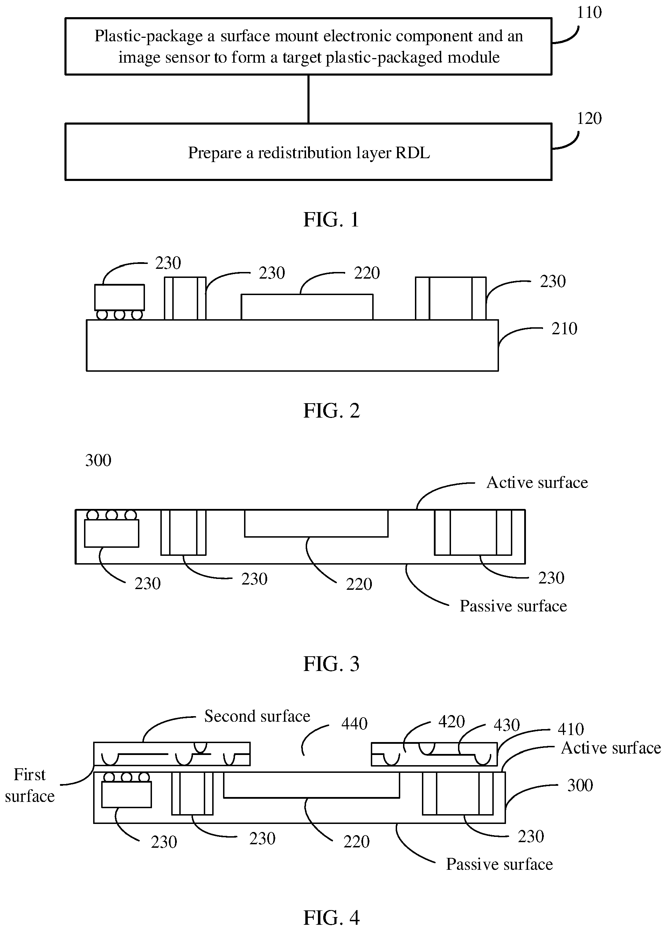

A method for assembling a camera assembly according to an embodiment of this application is described in detail below with reference to FIG. 1.

FIG. 1 is a schematic block diagram of a method for assembling a camera assembly according to an embodiment of this application. The assembly method shown in FIG. 1 may include steps 110-120. Steps 110-120 are described in detail below.

Step 110: Encapsulate a surface mount electronic component and an image sensor to form a target encapsulated module.

The surface mount electronic component is not specifically limited in this embodiment of this application. Optionally, by way of example, the surface mount electronic component may be a surface mount device (surface mount device, SMD). For example, the SMD may be a surface mount resistive component, a surface mount capacitive device, a small-outline transistor (small-outline transistor, SOT), a small outline integrated circuit (small outline integrated circuit, SOIC) component, or an array chip (for example, a ball grid array (ball grid array, BGA) component, or a micro lead frame (micro lead frame, MLF) component).

The surface mount device SMD may include, but is not limited to, at least one of the following models: 0201, 0402, 0603, 0805, 1206, 1210, or 2010. The SOT transistor may include, but is not limited to, at least one of the following models: SOT23, SOT143, or SOT89. The SOIC component may include, but is not limited to, at least one of the following models: SOIC08, SOIC14, SOIC16, SOIC18, SOIC20, SOIC24, SOIC28, or SOIC32. The BGA component may be a plastic ball grid array (plastic ball grid array, PBGA) component, an erasable programmable read only memory (erasable programmable read only memory, EPROM) component, or a ceramic plastic ball grid array (ceramic plastic ball grid array, CBGA) component.

In this embodiment of this application, an encapsulating process may be performed to position the surface mount electronic component and the image sensor.

Specifically, the molten epoxy resin can be injected into a mold using a high temperature injection molding technology, to wrap various components (for example, the image sensor and at least one surface mount electronic component) in the mold, so that an encapsulated module is formed and each component in the mold is positioned. A solder end of the surface mount electronic component and the solder end of the image sensor in the encapsulated module are exposed on the active surface of the encapsulated module. A specific implementation of forming the target encapsulated module will be described below with reference to FIG. 2, and therefore is not first described in detail herein.

### Step 120: Prepare an RDL.

In this embodiment of this application, the RDL may be prepared on a target encapsulated module formed through encapsulating in step 110. The RDL may include a dielectric layer and a plurality of metal wirings disposed at the dielectric layer, and at least a part of each metal wiring is disposed on a first surface of the dielectric layer or a second surface opposite the first surface. It should be understood that, for each metal wiring, the remaining part is located at the dielectric layer, except for the part that is located on the first surface or the second surface of the dielectric layer. The dielectric layer (which may also be referred to as a substrate) may be used to maintain insulation between portions of each metal wiring located at the dielectric layer and other electronic components located outside the dielectric layer. It should also be noted that the plurality of metal wirings include two or more metal wirings. It should be noted that the first surface of the dielectric layer is opposite the active surface of the target encapsulated module, or the first surface of the dielectric layer faces the active surface of the target encapsulated module. Accordingly, the second surface of the dielectric layer faces away from the first surface of the dielectric layer.

In this embodiment of this application, the metal wiring exposed on the first surface of the dielectric layer is connected to the solder ends that are of at least one surface mount electronic component and the image sensor and that are exposed on the active surface of the encapsulated module.

It should be noted that the first surface of the dielectric layer is also the first surface of the RDL, and the second surface of the dielectric layer is also the second surface of the RDL. That is, being exposed on the first surface of the dielectric layer can be understood as being exposed on the first surface of the RDL, and being exposed on the second surface of the dielectric layer can be understood as being exposed on the second surface of the RDL. For brevity, descriptions of the same or similar cases will be omitted below.

The RDL in this embodiment of this application is provided with a through-hole. The through-hole is opposite a photosensitive area of the image sensor in the encapsulated module, so that the photosensitive area of the image sensor is exposed, and a light signal can be transmitted to the photosensitive area of the image sensor through the through-hole on the RDL.

It should be understood that a specific implementation of preparing the RDL will be described below with reference to FIG. 4, and therefore is not first described in detail herein.

An embodiment of this application provides a camera assembly, so as to implement electrical connection between electronic components through metal wiring at a redistribution layer RDL. Because the RDL is thinner than the PCB board in a conventional camera module, the electrical connection between the electronic components is implemented by replacing the PCB with the RDL, so that the overall height of the camera module can be reduced.

Optionally, in some embodiments, the camera module may further include an infrared filter. An infrared filter can also be understood as an optical structure with infrared light filtering. The infrared filter can block the passage of filtered visible light while allowing the passage of infrared light, so that the infrared light can be separated in a light environment in which visible light and infrared light are mixed.

The position of the infrared filter is not specifically limited in this embodiment of this application. By way of example, the infrared filter may be fixed to the second surface of the RDL. In addition, the infrared filter is opposite the through-hole at the RDL, and the infrared filter and the image sensor in encapsulated module are respectively located on both sides of the RDL. As another example, the infrared filter may also be embedded in the through-hole at the RDL. As another example, the camera module may also include a holder, where the holder may be configured to support the infrared filter. The holder is fixed to the second surface of the RDL, and the infrared filter is opposite the through-hole at the RDL. The camera assemblies with the foregoing connection relationships will be described in detail below with reference to FIG. 4 to FIG. 6, and therefore are not first described in detail herein.

Specific implementations of forming a target encapsulated module through an injection molding process in this embodiment of this application are described in more detail below with reference to FIG. 2 and FIG. 3. It should be noted that the examples in FIG. 2 and FIG. 3 are merely intended to help those skilled in the art understand the embodiments of this application, and are not intended to limit the embodiments of this application to the specific values or specific scenarios illustrated. A person skilled in the art can apparently make various equivalent modifications or changes according to the examples shown in FIG. 2 to FIG. 3, and such modifications or changes also fall within the scope of the embodiments of this application.

FIG. 2 is a schematic structural diagram of an assembled electronic component according to an embodiment of this application. FIG. 2 may include a tray fixture 210, an image sensor 220, and an SMD device 230.

This embodiment of this application does not specifically limit the type of the image sensor 220. For example, a charge-coupled device (charge-coupled device, CCD) image sensor may be used, a complementary metal oxide semiconductor (complementary metal oxide semiconductor, CMOS) image sensor may be used, or a photoelectric image sensor may be used.

The tray fixture 210 may be a load-bearing fixture that covers the adhesive material (for example, glue) on one side. The SMD device 230 and the image sensor 220 may be attached to the tray tool 210 (by using glue) based on the design. After the SMD device 230 and the image sensor 220 are attached to the tray fixture 210, the SMD device 230 and the image sensor 220 may be encapsulated through an encapsulating process.

The encapsulating technology can be injecting molten epoxy into the surroundings of the SMD device 230 and the image sensor 220 using a high temperature injection molding technology, so as to wrap the SMD device 230 and the image sensor 220. Then the encapsulated module may be removed from the tray fixture 210.

Specifically, in the foregoing encapsulating procedure, the encapsulating time may be 20 to 40 seconds, the curing time may be 2 to 3 minutes, and the curing temperature may be 180°C.

For the encapsulated body removed from the tray fixture 210, reference may be made to FIG. 3.

FIG. 3 is a schematic structural diagram of a target encapsulated module 300 according to an embodiment of this application.

It should be understood that the target encapsulated module 300 may correspond to the encapsulated module described in FIG. 2.

Referring to FIG. 3, the target encapsulated module 300 may include an active surface and a passive surface (where the active surface of the target encapsulated module 300 is opposite the passive surface). Soldering pads (also referred to as pins) of the SMD device 230 and the image sensor 220 are exposed on the active surface. An RDL may be fabricated on the soldering pads to implement electrical connection between the SMD device 230 and the image sensor 220.

It should be noted that the side of the SMD device 230 and the side of the image sensor 220 that are in contact with the tray fixture 210 are not encapsulated because of the protection of the tray fixture 210. Therefore, the soldering pads of the SMD device 230 and the image sensor 220 may be exposed on the surface of the active surface of the target encapsulated module 300. The soldering pads that are of the SMD device 230 and the image sensor 220 and that are exposed on the surface of the active surface of the target encapsulated module 300 may be connected to metal wiring in the prepared RDL, so as to implement electrical connection between the SMD device 230 and the image sensor 220. A description will be provided below with reference to FIG. 4, so no detailed description is first provided herein. FIG. 4 is a schematic structural diagram of an RDL and the target encapsulated module 300 according to an embodiment of this application. The RDL 410 shown in FIG. 4 may be located on one side of the target encapsulated module 300 (for example, the active surface of the target encapsulated module 300). The procedure of preparing the RDL 410 on the active surface of the target encapsulated module 300 is described in detail below.

The dielectric layer 420 is located on the active surface of the target encapsulated module 300, or the dielectric layer 420 is located on the active surface side of the target encapsulated module 300. A metal wiring 430 is provided at the dielectric layer 420. An exposed part of the metal wiring 430 on the first surface of the dielectric layer 420 may be interconnected with the soldering pads that are of the SMD device 230 and the image sensor 220 and that are exposed on the active surface of the target encapsulated module 300, so as to implement electrical connection between the SMD device 230 and the image sensor 220.

It should be noted that the exposed part of the metal wiring 430 on the first surface of the dielectric layer 420 may be understood as that the metal wiring 430 is partially exposed on the first surface of the dielectric layer 420. In addition, the exposed part of the dielectric layer 420 on the first surface of the dielectric layer 420 may be connected to the soldering pads that are of the SMD device 230 and the image sensor 220 and that are exposed on the surface of the active surface of the target encapsulated module 300, so as to implement electrical connection between electronic components (for example, the image sensor 220 and the plurality of SMD devices 230 in FIG. 4).

The RDL 410 is provided with a through-hole 440. The through-hole 440 is opposite the photosensitive area of the image sensor 220, so that the photosensitive area of the image sensor 220 is exposed, and a light signal can be incident on the photosensitive area of the image sensor 220 through the through-hole 440 at the RDL 410.

In this embodiment of this application, the metal wiring 430 may be a metal material, for example, copper or aluminum. The dielectric layer 420 may be an insulating material, for example, polyimide (polyimide, PI), solder resist film (solder resist film, SRF), or benzocyclobutene (benzocyclobutene, BCB).

In this embodiment of this application, the thickness of each dielectric layer 420 may be designed to be 20 um; the line width of the metal wiring 430 may be designed to be 5 um; and the spacing between the at least one metal wiring 430 may be designed to be 5 um.

The RDL 410 may be prepared through processes such as sputtering deposition to a surface, anticorrosion coating, exposure molding with a line lithography system, development, and electrochemical deposition for implementing a copper line layer.

Optionally, in some embodiments, the camera module may further include an infrared filter and a motor. The infrared filter may be fixed to the second surface of the RDL. In addition, the infrared filter is opposite the through-hole at the RDL, and the infrared filter and the image sensor in encapsulated module are respectively located on both sides of the RDL. The motor may be fixed to the second surface of the RDL.

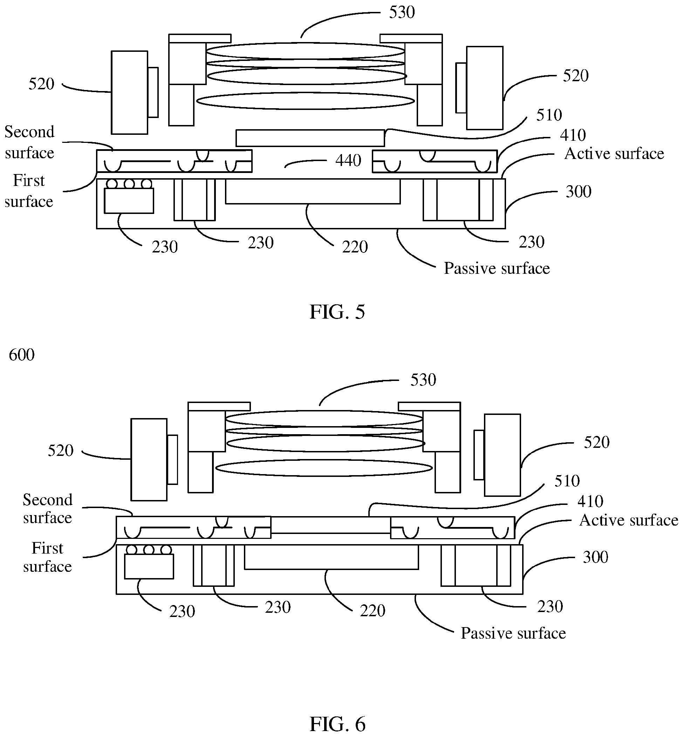

A possible camera assembly in an embodiment of this application is described in more detail below with reference to FIG. 5. It should be noted that the example in FIG. 5 is merely intended to help those skilled in the art understand this embodiment of this application, and is not intended to limit this embodiment of this application to the specific value or specific scenario illustrated. A person skilled in the art can apparently make various equivalent modifications or changes according to the examples shown in FIG. 5, and such modifications or changes also fall within the scope of the embodiments of this application.

FIG. 5 is a schematic structural diagram of a camera assembly 500 according to an embodiment of this application. The camera assembly 500 may include a target encapsulated module 300, an RDL 410, an infrared filter 510, a motor 520, and a lens 530. The target encapsulated module 300 is an image sensor 220 and a plurality of SMD devices 230.

The type of the motor 520 is not specifically limited in this embodiment of this application. The motor 520 may be, for example, a voice coil motor (voice coil motor, VCM) or an optical zoom motor.

Referring to FIG. 5, the infrared filter 510 is located on the second surface of the RDL 410. The motor 520 is also located on the second surface of the RDL 410, and the infrared filter 510 is isolated from the motor 520. The infrared filter 510 is opposite the through-hole 440 at the RDL 410, and the infrared filter 510 and the image sensor 220 are respectively located on both sides of the RDL 410.

Specifically, the infrared filter 510 may be fixed to the second surface of the RDL 410. Further, the motor 520 may be fixed to the second surface of the RDL 410. Still further, the lens 530 may be fixed to the side of the infrared filter 510 facing away from the RDL410 by the motor 520, so that light passing through the infrared filter 510 is incident on the photosensitive area of the image sensor 220 through the through-hole 440, and the assembly of the camera module 500 is completed.

It should be understood that this embodiment of this application does not limit the specific implementation of the fixing. By way of example, the fixing may be implemented using an adhesive material, and the adhesive material may be, for example, glue.

In this embodiment of this application, the infrared filter can be fixed to the second surface of the RDL, so that the overall height of the camera module can be reduced.

Optionally, in some embodiments, the camera module further includes an infrared filter and a motor. The infrared filter is fixed in the through-hole. It should be understood that the infrared filter 510 in the camera assembly 500 shown in FIG. 5 may be embedded in the through-hole 440 at the RDL 410. The motor is fixed to the second surface of the RDL.

Optionally, the outer side wall of the infrared filter 510 is in contact with the inner side wall of the through-hole 440.

Optionally, the infrared filter 510 is specifically clamped in the through-hole 440, so that the infrared filter 510 is fixed in the through-hole 440.

It should be understood that the clamping of the infrared filter 510 in the through-hole 440 means that the outer side wall of the infrared filter 510 and the inner side wall of the through-hole 440 are pressed against each other, so that the frictional force between them can carry the infrared filter 510, thereby fixing the infrared filter 510 in the through-hole 440.

A possible camera assembly in an embodiment of this application is described in more detail below with reference to FIG. 6. It should be noted that the example in FIG. 6 is merely intended to help those skilled in the art understand this embodiment of this application, and is not intended to limit this embodiment of this application to the specific value or specific scenario illustrated. A person skilled in the art can apparently make various equivalent modifications or changes according to the examples shown in FIG. 6, and such modifications or changes also fall within the scope of the embodiments of this application.

FIG. 6 is a schematic structural diagram of a possible camera assembly 600 according to an embodiment of this application. The camera assembly 600 may include a target encapsulated module 300, an RDL 410, an infrared filter 510, a motor 520, and a lens 530. The target encapsulated module 300 is an image sensor 220 and a plurality of SMD devices 230.

Referring to FIG. 6, the infrared filter 510 is located in the through-hole 440 of the RDL 410. One side of the infrared filter 510 is opposite the image sensor 220. The motor 520 is located on the second surface of the RDL 410.

Specifically, the infrared filter 510 may be fixed in the through-hole 440 at the RDL 410. Further, the motor 520 may be fixed to the second surface of the RDL 410. Still further, the lens 530 is fixed to the side of the infrared filter 510 facing away from the image sensor 220 by the motor 520, so that light passing through the infrared filter 510 is incident on the photosensitive area of the image sensor 220, and the assembly of the camera module 600 is completed.

It should be understood that this embodiment of this application does not limit the specific implementation of the fixing. By way of example, the fixing may be implemented using an adhesive material, and the adhesive material may be, for example, glue.

In this embodiment of this application, the infrared filter can be embedded (or clamped) in the through-hole at the RDL, thereby reducing the height of the camera module in the infrared filter.

Optionally, in some embodiments, the camera assembly further includes a holder, an infrared filter, and a motor. The holder may be configured to support the infrared filter 510 in the camera assembly 500 shown in FIG. 5. The holder is fixed to the second surface of the RDL. The infrared filter 510 is opposite the through-hole 440 at the RDL 410, and light passing through the infrared filter 510 is incident on the image sensor 220 through the through-hole 440. The motor is fixed to the holder, and the motor and the RDL are respectively located on both sides of the holder.

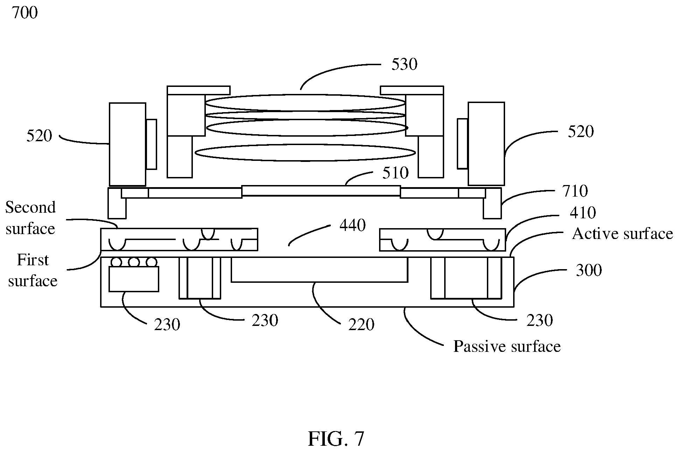

A possible camera assembly in an embodiment of this application is described in more detail below with reference to FIG. 7. It should be noted that the example in FIG. 7 is merely intended to help those skilled in the art understand this embodiment of this application, and is not intended to limit this embodiment of this application to the specific value or specific scenario illustrated. A person skilled in the art can apparently make various equivalent modifications or changes according to the examples shown in FIG. 7, and such modifications or changes also fall within the scope of the embodiments of this application.

FIG. 7 is a schematic structural diagram of a possible camera assembly 700 according to an embodiment of this application. The camera assembly 700 may include a target encapsulated module 300, an RDL 410, an infrared filter 510, a motor 520, a lens 530, and a holder 710. The target encapsulated module 300 is an image sensor 220 and a plurality of SMD devices 230.

Referring to FIG. 7, the holder 710 is located on the second surface of the RDL 410. The holder 710 may be configured to support the infrared filter 510. The infrared filter 510 is opposite the through-hole 440 at the RDL 410, and the infrared filter 510 and the image sensor 220 are respectively located on both sides of the RDL410. Further, the motor 520 is located on the holder 710, and the motor 520 and the RDL 410 are respectively located on both sides of the holder 710.

Specifically, the holder 710 may be fixed to the second surface of the RDL 410. Further, the infrared filter 510 may be fixed to the holder 710. Still further, the motor 520 may be fixed to the holder 710, and the motor 520 and the RDL 410 are respectively located on both sides of the holder 710. Still further, the lens 530 may be fixed to the side of the infrared filter 510 facing away from the RDL410 by the motor 520, so that light passing through the infrared filter 510 is incident on the photosensitive area of the image sensor 220 through the through-hole 440, and the assembly of the camera module 700 is completed.

It should be understood that this embodiment of this application does not limit the specific implementation of the fixing. By way of example, the fixing may be implemented using an adhesive material, and the adhesive material may be, for example, glue.

In this embodiment of this application, the infrared filter can be fixed to the second surface of the RDL using the holder, so that the infrared filter can be closer to the lens, and the infrared light can be better blocked from entering the image sensor.

It should be understood that, the term "and/or" in the embodiments of this application describes only an association relationship for describing associated objects and represents that three relationships may exist. For example, A and/or B may represent the following cases: Only A exists, both A and B exist, and only B exists. In addition, the character "/" in this specification generally indicates an "or" relationship between the associated objects.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A method for assembling a camera assembly (500, 600,700) wherein the method comprises:
encapsulating a surface mount electronic component (230) and an image sensor (220) to form a target encapsulated module, where the target encapsulated module includes an active surface, and a solder end of the surface mount electronic component and a solder end of the image sensor are exposed on the active surface;
preparing a redistribution layer RDL (410) and drilling the RDL to form a through-hole (440) where the through-hole is opposite to a photosensitive area of the image sensor, the RDL includes a dielectric layer (420) and metal wiring (430)
disposed at the dielectric layer, and the metal wiring is at least partially exposed on a first surface of the RDL; and connecting the metal wiring exposed on the first surface of the RDL to the solder end of the surface mount electronic component and the solder end of the image sensor on the active surface of the target encapsulated module.

2. The method according to claim 1, wherein the method further comprises:
fixing an infrared filter (510)
to a second surface of the RDL, wherein the second surface of the RDL faces away from the first surface of the RDL, the infrared filter is opposite to the through-hole, and light passing through the infrared filter is incident on the image sensor through the through-hole.

3. The method according to claim 2, , wherein the infrared filter is fixed in the through-hole.

4. The method of claim 2 or 3, further comprising: fixing a motor (520) to the second surface of the RDL.

5. The method according to claim 1, further comprising:
fixing a holder (710) to the second surface of the RDL, wherein the holder is configured to support the infrared filter, the infrared filter is opposite to the through-hole, and light passing through the infrared filter is incident on the image sensor through the through-hole.

6. The method according to claim 5, wherein a motor is fixed to the holder, and the motor and the RDL are respectively located on both sides of the holder.

7. The method according to any one of claims 1 to 6, wherein the encapsulating a surface mount electronic component and an image sensor to form a target encapsulated module comprises:
placing the surface mount electronic component and the image sensor on a tray fixture; and
wrapping the surface mount electronic component and the image sensor by an encapsulating material.

8. A camera assembly (500,600,700), comprising:
a target encapsulated module encapsulated with a surface mount electronic component (230) and an image sensor (220),
wherein the target encapsulated module comprises an active surface, and a solder end of the surface mount electronic component and a solder end of the image sensor are exposed on the active surface; and
a redistribution layer RDL (410) with a through-hole (440), wherein the through-hole is opposite to a photosensitive area of the image sensor, the RDL comprises a dielectric layer (420) and metal wiring (430) disposed at the dielectric layer, the metal wiring is at least partially exposed on a first surface of the RDL, and
**characterised in that** the
metal wiring exposed on the first surface of the RDL is connected to the solder end of the surface mount electronic component and the solder end of the image sensor on the active surface of the target encapsulated module.

9. The camera assembly according to claim 8, further comprising:
an infrared filter, wherein the infrared filter is fixed to a second surface of the RDL, the second surface of the RDL faces away from the first surface of the RDL, the infrared filter is opposite to the through-hole, and light passing through the infrared filter is incident on the image sensor through the through-hole.

10. The camera assembly according to claim 8, further comprising an infrared filter, wherein the infrared filter is fixed in the through-hole.

11. The camera assembly according to claim 9 or 10, further comprising:
a motor, wherein the motor is fixed to the second surface of the RDL.

12. The camera assembly according to claim 8, further comprising a holder and an infrared filter, wherein
the holder is configured to support the infrared filter, the holder is fixed to the second surface of the RDL, the infrared filter is opposite to the through-hole, and light passing through the infrared filter is incident on the image sensor through the through-hole.

13. The camera assembly according to claim 12, further comprising a motor, wherein the motor is fixed to the holder, and the motor and the RDL are respectively located on both sides of the holder.

14. The camera assembly according to any one of claims 8 to 13, wherein the target encapsulated module further comprises an encapsulating material, and the encapsulating material surrounds a surface mount electronic component in the target encapsulated module and an image sensor.

15. A terminal, comprising a camera assembly according to any one of claims 8 to 14 and a processor configured to control the camera assembly.

## Patentansprüche

1. Verfahren zum Montieren einer Kameraanordnung (500, 600, 700), wobei das Verfahren Folgendes umfasst:
Kapseln einer oberflächenmontierten elektronischen Komponente (230) und eines Bildsensors (220), um ein gekapseltes Zielmodul zu bilden, wo das gekapselte Zielmodul eine aktive Fläche beinhaltet und ein Lotende der oberflächenmontierten elektronischen Komponente und ein Lotende des Bildsensors auf der aktiven Fläche freiliegen;
Vorbereiten einer Umverteilungsschicht RDL (410) und Bohren der RDL, um ein Durchgangsloch (440) zu bilden, wo das Durchgangsloch einem photosensitiven Bereich des Bildsensors gegenüberliegt, die RDL eine Dielektrikumschicht (420) und eine Metallverdrahtung (430), die an der Dielektrikumschicht angeordnet ist, beinhaltet und die Metallverdrahtung mindestens teilweise auf einer ersten Fläche der RDL freiliegt; und
Verbinden der Metallverdrahtung, die auf der ersten Fläche der RDL freiliegt, mit dem Lotende der oberflächenmontierten elektronischen Komponente und dem Lotende des Bildsensors auf der aktiven Fläche des gekapselten Zielmoduls.

2. Verfahren nach Anspruch 1, wobei das Verfahren ferner Folgendes umfasst:
Befestigen eines Infrarotfilters (510) an einer zweiten Fläche der RDL, wobei die zweite Fläche der RDL der ersten Fläche der RDL abgewandt ist, der Infrarotfilter dem Durchgangsloch gegenüberliegt und Licht, das durch den Infrarotfilter verläuft, durch das Durchgangsloch auf den Bildsensor einfällt.

3. Verfahren nach Anspruch 2, wobei der Infrarotfilter im Durchgangsloch befestigt ist.

4. Verfahren nach Anspruch 2 oder 3, das ferner Folgendes umfasst: Befestigen eines Motors (520) an der zweiten Fläche der RDL.

5. Verfahren nach Anspruch 1, das ferner Folgendes umfasst:
Befestigen eines Halters (710) an der zweiten Fläche der RDL, wobei der Halter dazu ausgelegt ist, den Infrarotfilter zu stützen, der Infrarotfilter dem Durchgangsloch gegenüberliegt und Licht, das durch den Infrarotfilter verläuft, durch das Durchgangsloch auf den Bildsensor einfällt.

6. Verfahren nach Anspruch 5, wobei ein Motor am Halter befestigt ist und sich der Motor und die RDL jeweils auf beiden Seiten des Halters befinden.

7. Verfahren nach einem der Ansprüche 1 bis 6, wobei das Kapseln einer oberflächenmontierten elektronischen Komponente und eines Bildsensors, um ein gekapseltes Zielmodul zu bilden, Folgendes umfasst:
Platzieren der oberflächenmontierten elektronischen Komponente und des Bildsensors auf einer Ablageeinrichtung und
Umwickeln der oberflächenmontierten elektronischen Komponente und des Bildsensors mit einem Kapselmaterial.

8. Kameraanordnung (500, 600, 700), die Folgendes umfasst:
ein gekapseltes Zielmodul, das mit einer oberflächenmontierten elektronischen Komponente (230) und einem Bildsensor (220) gekapselte ist,
wobei das gekapselte Zielmodul eine aktive Fläche umfasst und ein Lotende der oberflächenmontierten elektronischen Komponente und ein Lotende des Bildsensors auf der aktiven Fläche freiliegen; und
eine Umverteilungsschicht RDL (410) mit einem Durchgangsloch (440),
wobei das Durchgangsloch einem photosensitiven Bereich des Bildsensors gegenüberliegt, die RDL eine Dielektrikumschicht (420) und eine Metallverdrahtung (430), die an der Dielektrikumschicht angeordnet ist, umfasst, die Metallverdrahtung mindestens teilweise auf einer ersten Fläche der RDL freiliegt, und
**dadurch gekennzeichnet, dass** die Metallverdrahtung, die auf der ersten Fläche der RDL freiliegt, mit dem Lotende der oberflächenmontierten elektronischen Komponente und dem Lotende des Bildsensors auf der aktiven Fläche des gekapselten Zielmoduls verbunden ist.

9. Kameraanordnung nach Anspruch 8, die ferner Folgendes umfasst:
einen Infrarotfilter, wobei der Infrarotfilter an einer zweiten Fläche der RDL befestigt ist, die zweite Fläche der RDL der ersten Fläche der RDL abgewandt ist, der Infrarotfilter dem Durchgangsloch gegenüberliegt und Licht, das durch den Infrarotfilter verläuft, durch das Durchgangsloch auf den Bildsensor einfällt.

10. Kameraanordnung nach Anspruch 8, die ferner einen Infrarotfilter umfasst, wobei der Infrarotfilter im Durchgangsloch befestigt ist.

11. Kameraanordnung nach Anspruch 9 oder 10, die ferner Folgendes umfasst:
einen Motor, wobei der Motor an der zweiten Fläche der RDL befestigt ist.

12. Kameraanordnung nach Anspruch 8, die ferner einen Halter und einen Infrarotfilter umfasst, wobei
der Halter dazu ausgelegt ist, der Infrarotfilter zu stützen, der Halter an der zweiten Fläche der RDL befestigt ist, der Infrarotfilter dem Durchgangsloch gegenüberliegt und Licht, das durch den Infrarotfilter verläuft, durch das Durchgangsloch auf den Bildsensor einfällt.

13. Kameraanordnung nach Anspruch 12, die ferner einen Motor umfasst, wobei der Motor am Halter befestigt ist und sich der Motor und die RDL jeweils auf beiden Seiten des Halters befinden.

14. Kameraanordnung nach einem der Ansprüche 8 bis 13, wobei das gekapselte Zielmodul ferner ein Kapselmaterial umfasst und das Kapselmaterial eine oberflächenmontierte elektronische Komponente im gekapselten Zielmodul und einen Bildsensor umgibt.

15. Endgerät, das eine Kameraanordnung nach einem der Ansprüche 8 bis 14 sowie einen Prozessor umfasst, der dazu ausgelegt ist, die Kameraanordnung zu steuern.

## Revendications

1. Procédé d'assemblage d'un ensemble caméra (500, 600, 700) dans lequel le procédé comprend :
l'encapsulation d'un composant électronique de montage en surface (230) et d'un capteur d'image (220) pour former un module encapsulé cible, où le module encapsulé cible comporte une surface active, et une extrémité de soudure du composant électronique de montage en surface et une extrémité de soudure du capteur d'image sont exposées sur la surface active ;
la préparation d'une couche de redistribution RDL (410) et le perçage de la RDL pour former un trou traversant (440) où le trou traversant est opposé à une zone photosensible du capteur d'image, la RDL comporte une couche diélectrique (420) et un câblage métallique (430) disposé au niveau de la couche diélectrique, et le câblage métallique est au moins partiellement exposé sur une première surface de la RDL ; et la connexion du câblage métallique exposé sur la première surface de la RDL à l'extrémité de soudure du composant électronique de montage en surface et à l'extrémité de soudure du capteur d'image sur la surface active du module encapsulé cible.

2. Procédé selon la revendication 1, dans lequel le procédé comprend en outre :
la fixation d'un filtre infrarouge (510) sur une seconde surface de la RDL, dans lequel la seconde surface de la RDL est tournée à l'opposé de la première surface de la RDL, le filtre infrarouge est opposé au trou traversant, et la lumière passant à travers le filtre infrarouge est incidente sur le capteur d'image à travers le trou traversant.

3. Procédé selon la revendication 2, dans lequel le filtre infrarouge est fixé dans le trou traversant.

4. Procédé selon la revendication 2 ou 3, comprenant en outre :
la fixation d'un moteur (520) sur la seconde surface de la RDL.

5. Procédé selon la revendication 1, comprenant en outre :
la fixation d'un support (710) à la seconde surface de la RDL, dans lequel le support est configuré pour supporter le filtre infrarouge, le filtre infrarouge est opposé au trou traversant, et la lumière traversant le filtre infrarouge est incidente sur le capteur d'image à travers le trou traversant.

6. Procédé selon la revendication 5, dans lequel un moteur est fixé au support, et le moteur et la RDL sont respectivement situés de part et d'autre du support.

7. Procédé selon l'une quelconque des revendications 1 à 6, dans lequel l'encapsulation d'un composant électronique de montage en surface et d'un capteur d'image pour former un module encapsulé cible comprend :
le placement du composant électronique de montage en surface et du capteur d'image sur un support de plateau ; et
l'enveloppement du composant électronique de montage en surface et du capteur d'image par un matériau d'encapsulation.

8. Ensemble caméra (500, 600, 700), comprenant :
un module encapsulé cible encapsulé avec un composant électronique de montage en surface (230) et un capteur d'image (220),
dans lequel le module encapsulé cible comprend une surface active, et une extrémité de soudure du composant électronique de montage en surface et une extrémité de soudure du capteur d'image sont exposées sur la surface active ; et
une couche de redistribution RDL (410) avec un trou traversant (440),
dans lequel le trou traversant est opposé à une zone photosensible du capteur d'image, la RDL comprend une couche diélectrique (420) et un câblage métallique (430) disposé au niveau de la couche diélectrique, le câblage métallique est au moins partiellement exposé sur une première surface de la RDL,
et
**caractérisé en ce que** le câblage métallique exposé sur la première surface de la RDL est connecté à l'extrémité de soudure du composant électronique de montage en surface et à l'extrémité de soudure du capteur d'image sur la surface active du module encapsulé cible.

9. Ensemble caméra selon la revendication 8, comprenant en outre :
un filtre infrarouge, dans lequel le filtre infrarouge est fixé à une seconde surface de la RDL, la seconde surface de la RDL est tournée à l'opposé de la première surface de la RDL, le filtre infrarouge est opposé au trou traversant, et la lumière passant à travers le filtre infrarouge est incidente sur le capteur d'image à travers le trou traversant.

10. Ensemble caméra selon la revendication 8, comprenant en outre un filtre infrarouge, dans lequel le filtre infrarouge est fixé dans le trou traversant.

11. Ensemble caméra selon la revendication 9 ou 10, comprenant en outre :
un moteur, dans lequel le moteur est fixé à la seconde surface de la RDL.

12. Ensemble caméra selon la revendication 8, comprenant en outre un support et un filtre infrarouge, dans lequel le support est configuré pour supporter le filtre infrarouge, le support est fixé à la seconde surface de la RDL, le filtre infrarouge est opposé au trou traversant, et la lumière traversant le filtre infrarouge est incidente sur le capteur d'image à travers le trou traversant.

13. Ensemble caméra selon la revendication 12, comprenant en outre un moteur, dans lequel le moteur est fixé au support, et le moteur et la RDL sont respectivement situés des deux côtés du support.

14. Ensemble caméra selon l'une quelconque des revendications 8 à 13, dans lequel le module encapsulé cible comprend en outre un matériau d'encapsulation, et le matériau d'encapsulation entoure un composant électronique de montage en surface dans le module encapsulé cible et un capteur d'image.

15. Terminal, comprenant un ensemble caméra selon l'une quelconque des revendications 8 à 14 et un processeur configuré pour commander l'ensemble caméra.
